**Europäisches Patentamt**

**European Patent Office**

**Office européen des brevets**

(19)

(11) Veröffentlichungsnummer: **0 189 777 B1**

(12) **EUROPÄISCHE PATENTSCHRIFT**

(45) Veröffentlichungstag der Patentschrift:
25.07.90

(51) Int. Cl.5: **G01R 31/28**, G01R 31/02

(21) Anmeldenummer: **86100378.8**

(22) Anmeldetag: **13.01.86**

(54) Korpuskularstrahl-Messverfahren zum berührungslosen Testen von Leitungsnetzwerken.

(30) Priorität: **18.01.85 DE 3501562**

(43) Veröffentlichungstag der Anmeldung:
**06.08.86 Patentblatt 86/32**

(45) Bekanntmachung des Hinweises auf die Patenterteilung:
**25.07.90 Patentblatt 90/30**

(84) Benannte Vertragsstaaten:
**DE FR GB IT NL**

(56) Entgegenhaltungen:
**EP-A- 0 066 070**

**11th ANNUAL PROCEEDINGS IN RELIABILITY PHYSICS, 3.-5. April 1973, Las Vegas, US, Seiten 138-145, IEEE, New York, US; J.M. SEBESON et al.: "Noncontact testing of interconnections in film integrated circuits using an electron beam"**
**IEEE TRANSACTIONS ON ELECTRON DEVICES, Band ED-26, Nr. 4, April 1979, Seiten 549-559, IEEE, New York, US; E. WOLFGANG et al.: "Electron-beam testing of VLSI circuits"**
**JOURNAL OF PHYSICS D: APPL. PHYS., Band 3, Nr. 10, Oktober 1970, Seiten 1505-1508, Letchword, GB; J.M. ENGEL et al.: "Electron beam testing of wired or printed circuit boards"**

(73) Patentinhaber: **Siemens Aktiengesellschaft, Wittelsbacherplatz 2, D-8000 München 2(DE)**

(72) Erfinder: **Brunner, Matthias, Dr., Graf-Andechs-Strasse 30, D-8011 Kirchheim(DE)**
Erfinder: **Frosien, Jürgen, Dr.-Ing., An der Ottosäule 18, D-8012 Ottobrunn(DE)**
Erfinder: **Schmitt, Reinhold, Dipl.-Ing., Josef-Kiefer-Weg 6, D-8000 München 83(DE)**
Erfinder: **Lischke, Burkhard, Prof. Dr., In der Heuluss 13, D-8000 München 82(DE)**

**Beschreibung**

Die Erfindung bezieht sich auf ein Korpuskularstrahl-Meßverfahren zum berührungslosen Testen von Leitungsnetzwerken auf Kurzschlüsse und Unterbrechungen gemäß dem Oberbegriff des Anspruchs 1 (vgl. den Stand der Technik auf Seite 3, Abs. 2).

Infolge des steigenden Integrationsgrades und der fortschreitenden Miniaturisierung von Halbleiterbauelementen wurde es notwendig, auch die Dimensionen der die elektrische Verbindung zwischen verschiedenen VLSI-Schaltungen herstellenden Leitungsnetzwerke entsprechend zu reduzieren. Die Forderung, auf kleinstem Raum eine Vielzahl von Kontaktpunkten verschalten zu müssen, führte daher auf dem Gebiet der Verdrahtungstechnologie u.a. zur Entwicklung von keramischen Vielschichtmodulen. Die Kontaktpunktdichte auf diesen Modulen ist inzwischen so hoch, daß eine Überprüfung ihrer elektrischen Eigenschaften mit mechanischen Kontaktspitzen nur noch unter großen Schwierigkeiten durchführbar ist. Deshalb werden in zunehmendem Maße Elektronenstrahl-Meßgeräte zum berührungslosen Testen von Leitungsnetzwerken auf Kurzschlüsse und Unterbrechungen eingesetzt. Ein solches Elektronenstrahl-Meßverfahren ist in IBM Techn.Discl.Bull. Vol.24, Nr.11a auf den Seiten 5388-5290 beschrieben. Eine Anordnung zur Durchführung eines solchen Verfahrens ist beispielsweise aus der europäischen Patentschrift EP-B-0 066 086 bekannt (siehe hierbei besonders Fig.12 und den zugehörigen Beschreibungsteil).

Grundlage dieser bekannten Verfahren ist die Möglichkeit, mit Elektronenstrahlen auf einer isolierten Probe Potentiale aufzubringen bzw. vorhandene Potentialverteilungen durch Detektieren der von dem Primärelektronenstrahl ausgelösten Sekundärelektronen nachzuweisen. Zur Überprüfung eines Leitungsnetzwerkes wird mindestens einer der Kontaktpunkte mit einem ersten Elektronenstrahl aufgeladen und anschließend die sich entsprechend der Netzwerkgeometrie aufbauende Ladungs- bzw. Potentialverteilung mit einem zweiten Elektronenstrahl abgetastet. Zum Aufbringen und Lesen der Potentiale wird hierbei mit Elektronenstrahlen unterschiedlicher Energie gearbeitet.

Der Nachweis von Kurzschlüssen und Unterbrechungen in einem Netzwerk kann dann durch Vergleich der an verschiedenen Kontaktpunkten gemessenen Sekundärelektronensignale erfolgen. Wird beispielsweise an einem der Kontaktpunkte das gleiche Potential wie am Aufladepunkt beobachtet, d.h. registriert man in einem Sekundärelektronen-Detektorsystem innerhalb der Meßgenauigkeit bei idealer Detektorcharakteristik den gleichen Sekundärelektronenstrom, so sind beide Punkte notwendigerweise leitend miteinander verbunden. Unterscheiden sich hingegen die Sekundärelektronenströme erheblich voneinander, muß eine Unterbrechung vorliegen.

Um eine Änderung der Potentiale während des Abtastens mit dem Lesestrahl zu verhindern, arbeitet man bei dem bekannten Verfahren mit Primärenergien im Bereich des Neutralpunktes. Da sich unter diesen Bedingungen der auf die Probe auftreffende Primärelektronenstrom und der von der Probe ausgehende Sekundärelektronenstrom gerade kompensieren, muß die Primärelektronenenergie beim Wechsel zwischen Lade- und Lesephase geändert werden. Dies wird technisch gelöst, indem man mit mehreren Elektronenstrahlen unterschiedlicher Energie arbeitet oder die Hochspannungsversorgung eines Elektronenstrahles umschaltet. Beide Lösungen weisen aber entscheidende Nachteile auf. So sind beim Umschalten der Hochspannungsversorgung eines Elektronenstrahl-Meßgeräts elektronenoptische Maßnahmen erforderlich, um die Position und Fokussierung des Strahls auf der Probe beizubehalten. Zusätzlich treten die bekannten elektronischen Schwierigkeiten beim Schalten hoher Spannungen auf. Auch die Verwendung mehrerer Elektronenstrahlen erfordert einen erheblichen Mehraufwand an elektronenoptischen Komponenten, da zusätzliche Elektronenquellen und Linsen zur Strahlformung vorhanden sein müssen.

Aus JOURNAL OF PHYSICS D: APPL. PHYS., Bd. 3, Nr. 10, October 1970, S. 1505-1508 ist ein Testverfahren bekannt, bei dem man ein Leitungsnetzwerk mit Hilfe eines Elektronenstrahls auflädt und die sich entsprechend der Netzwerkgeometrie aufbauende Potentialverteilung anschließend mit demselben Elektronenstrahl abtastet. Während der Abtastphase ist man allerdings gezwungen, den Strahlstrom erheblich zu reduzieren. Unter diesen Umständen entlädt sich das Netzwerk infolge von Leckströmen, was die verfügbare Meßzeit zur Abtastung der Testpunkte begrenzt. Außerdem verlängert sich die Zeit zur Bestimmung des jeweiligen Testpunktpotentials, da die Verringerung des Strahlstroms eine entsprechende Verringerung des Sekundärelektronenstroms zur Folge hat.

Aus 11th ANNUAL PROCEEDINGS IN RELIABILITY PHYSICS, 3.-5. April 1973, Las Vegas, US, S. 138-145, IEEE, New York ist ein Testverfahren bekannt, bei dem man das zu prüfende Netzwerk periodisch aufladen und anschließend wieder entladen muß. Innerhalb einer Periode des Testzyklus wird hierbei der Ladungszustand jeweils eines Testpunktes mit Hilfe eines Elektronenstrahls bestimmt. Als Bewertungskriterium für den Ladungszustand dient die Zeitabhängigkeit des in einem Detektor gemessenen Sekundärelektronenstroms.

Der Erfindung liegt die Aufgabe zugrunde, ein Korpuskularstrahl-Meßverfahren, insbesondere ein Elektronenstrahl-Meßverfahren der eingangs genannten Art anzugeben, bei dem Potentiale mit nur einem Elektronenstrahl an einem zu untersuchenden Leitungsnetzwerk erzeugt und gelesen werden können, ohne die Primärelektronenenergie ändern zu müssen. Dies wird erfindungsgemäß durch eine Ausgestaltung des eingangs genannten Verfahrens nach dem kennzeichnenden Teil des Patentanspruchs 1 erreicht.

Der mit der Erfindung erzielbare Vorteil besteht insbesondere darin, daß sich die technische Ausführung eines Elektronenstrahl-Meßgeräts zur Überprüfung von Leitungsnetzwerken auf Kurzschlüsse und Unterbrechungen wesentlich vereinfacht.

Die abhängigen Ansprüche sind auf bevorzugte Ausgestaltungen und Weiterbildungen des erfindungsgemäßen Verfahrens gerichtet.

Das erfindungsgemäße Elektronenstrahl-Meßverfahren wird im folgenden anhand der Zeichnungen erläutert. Hierbei zeigt:

Fig. 1 im Ausschnitt mehrere Netzwerke einer Leiterplatte,

Fig.2 ein Ausführungsbeispiel einer Anordnung zur Durchführung des erfindungsgemäßen Verfahrens.

Grundlage des erfindungsgemäßen Verfahrens ist die Möglichkeit, mit einem Elektronenstrahl auf einer isolierten Probe Potentiale aufbringen und lesen zu können. Zum Aufladen der Probe muß hierbei die Elektronen-Energie so gewählt werden, daß sich der auf die Probe auftreffende Primärelektronenstrom und der von der Probe ausgehende Sekundärelektronenstrom nicht kompensieren. Dies ist immer dann der Fall, wenn die Primärelektronen-Energie nicht mit der Neutralpunkt-Energie zusammenfällt. Die Neutralpunkt-Energie ist materialabhängig und liegt typischerweise im Bereich zwischen einem und mehreren keV. Durch genügend langes Bestrahlen lassen sich somit auf einer Probe Ladungen bzw. Potentiale jedes Vorzeichens mit einem Elektronenstrahl aufbringen.

Da sich umgekehrt die Energieverteilung der emittierten Sekundärelektronen durch vorhandene Probenpotentiale ändert, können durch Nachweis der Sekundärelektronen in geeigneten Detektoren qualitative oder bei Verwendung von Sekundärelektronen-Spektrometern auch quantitative Potentialmessungen durchgeführt werden. Meßgröße ist hierbei jeweils der im Detektor beobachtete Sekundärelektronenstrom. Die gemessenen Sekundärelektronen-Signale sind eventuell durch Vergleich mit Eichsignalen zu korrigieren, da die Energieverteilung der emittierten Sekundärelektronen außer vom Probenpotential auch von lokalen elektrischen Feldern am Auftreffpunkt des Strahles beeinflußt wird. Zur Eichung eigenen sich beispielsweise die an ungeladenen Punkten gemessenen Sekundärelektronen-Signale, wobei die Punkte vorzugsweise gleichmäßig über die Probe verteilt sind.

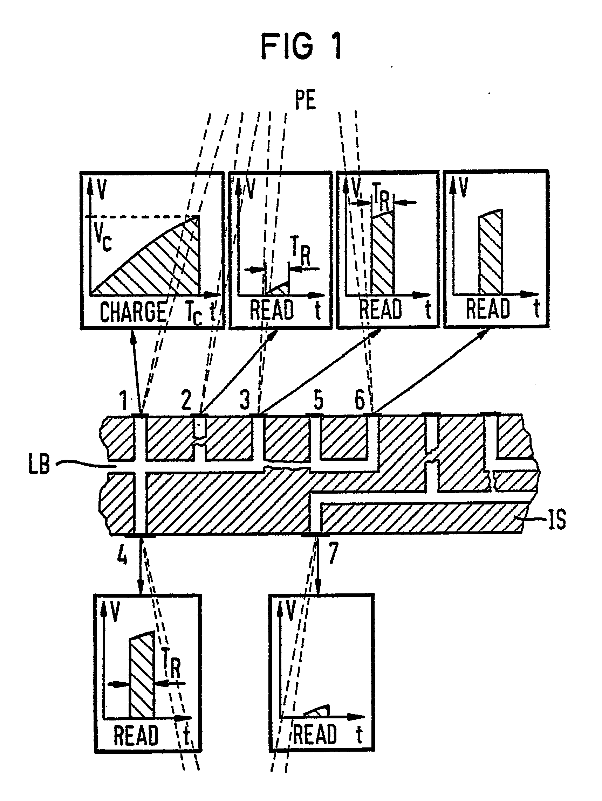

Zum Überprüfen einer Leiterplatte oder eines Verdrahtungsmoduls auf Kurzschlüsse oder Unterbrechungen wird bei dem erfindungsgemäßen Verfahren zuerst ein Punkt des zu untersuchenden Netzwerkes durch genügend langes Bestrahlen mit einem Elektronenstrahl in einer Zeit $T_C$ auf die Spannung $V_C$ aufgeladen und anschließend alle anderen Netzwerkpunkte nacheinander mit dem gleichen Elektronenstrahl und unveränderter Primärenergie in der Zeit $T_R$ abgetastet. Wird an einem dieser Punkte im Sekundärelektronen-Detektor innerhalb der Meßgenauigkeit nach eventuell notwendigen Korrekturen der gleiche Sekundärelektronenstrom, also die gleiche Spannung $V_C$, beobachtet, so sind die beiden Punkte notwendigerweise leitend miteinander verbunden. Unterscheiden sich hingegen die gemessenen Potentiale wesentlich voneinander, muß eine Unterbrechung vorliegen. Um Verfälschungen des Meßergebnisses durch das Aufladen der Netzwerkpunkte während der Meßphase zu verhindern, ist die Meßzeit $T_R$ bezüglich der zum Aufladen des Netzwerkes benötigten Zeit $T_C$ entsprechend der unten angegebenen Bedingung zu reduzieren. Zur weiteren Erläuterung des erfindungsgemäßen Verfahrens wird im folgenden auf Figur 1 Bezug genommen.

Die schematische Zeichnung zeigt im Ausschnitt mehrere Netzwerke einer Leiterplatte. Die die verschiedenen Kontaktpunkte (1 bis 7) verbindenden Leiterbahnen LB sind hierbei in eine schraffiert dargestellte Isolationsschicht IS eingebettet. Aufgrund der technischen Auslegung sollen die Kontaktpunkte 1 bis 4 leitend miteinander verbunden sein und das Netzwerk A bilden. Ebenso sollen die Kontaktpunkte 5 und 6 zu einem gegenüber Netzwerk A isoliert liegenden Netzwerk B zusammengefaßt sein. Entsprechendes gilt für die anderen in der Zeichnung nicht weiter gekennzeichneten Kontaktpunkte. Ohne Einschränkung der Allgemeinheit kann angenommen werden, daß die Netzwerke zu Beginn des Prüfverfahrens nicht geladen sind. Zur Überprüfung der elektrischen Eigenschaften der Netzwerke A und B wird bei dem erfindungsgemäßen Verfahren der in der Zeichnung punktiert dargestellte Elektronenstrahl PE auf einen der Kontaktpunkte des Netzwerkes A, also z.B. auf Punkt 1, gerichtet. Da die Primärelektronen-Energie nicht mit der Neutralpunkt-Energie zusammenfällt, lädt sich der Kontaktpunkt 1 in einer von der Kapazität des Netzwerkes abhängigen Zeit $T_C$ bis zu einer Spannung $V_C$ auf. Die Zeitabhängigkeit der aufgebrachten Spannung $V_C$ ist im oberen linken Teil der Fig.1 in Form eines Diagrammes dargestellt. Die Aufladung des Netzwerkes auf die Spannung $V_C$ kann vorteilhafterweise über das Sekundärelektronen-Signal eines Elektronen-Detektors oder eines Sekundärelektronen-Spektrometers kontrolliert werden. Ist die gewünschte Aufladespannung $V_C$ erreicht, wird der Elektronenstrahl ausgetastet und anschließend bei unveränderter Primärenergie auf einen anderen Kontaktpunkt des Netzwerkes A gerichtet, um während der Meßzeit $T_R$ den an einem Detektor auftreffenden Sekundärelektronenstrom zu registrieren. Beobachtet man innerhalb der Meßgenauigkeit den gleichen Sekundärelektronenstrom, also die gleiche Spannung $V_C$ wie am Aufladepunkt 1, so sind dieser und der Meßpunkt leitend miteinander verbunden. Diese Situation ist für den Kontaktpunkt 3 verwirklicht. Aufgrund einer Unterbrechung im Netzwerk A ist im Gegensatz hierzu der Kontaktpunkt 2 nicht geladen. Beim Abtasten dieses Punktes mit dem Elektronenstrahl PE beobachtet man deshalb wegen der starken Abhängigkeit des im Detektor meßbaren Sekundärelektronen-Signals vom Kontaktpunktpotential während der Meßzeit $T_R$ einen anderen Sekundärelektronenstrom. Anhand der durch Detektieren der Sekundärelektronen nachweisbaren Spannungsunterschiede lassen sich Kurzschlüsse und Unterbrechungen feststellen. Wie in dem Diagramm der Fig.1 oben rechts angedeutet ist, wird auch beim Abtasten des Kontaktpunktes 6 innerhalb der Meß-

genauigkeit die gleiche Spannung $V_C$ wie am Aufladepunkt 1 gemessen. Damit ist dieser Punkt leitend mit dem Aufladepunkt 1 verbunden, so daß ein nicht erwünschter Kurzschluß zwischen den Netzwerken A und B nachgewiesen ist. Zur Messung des Potentials der auf der Unterseite der Leiterplatte angeordneten Kontaktpunkte 4 und 7 werden diese mit einem zweiten Elektronenstrahl gleicher Energie abgetastet. Während am Kontaktpunkt 4 die Spannung $V_C$ beobachtet wird, ist der Kontaktpunkt 7 ungeladen und damit nicht mit dem Netzwerk A kurzgeschlossen. Die Zeitabhängigkeit der an diesen Kontaktpunkten gemessenen Spannungen ist in den Diagrammen im unteren Teil der Fig.1 dargestellt.

Bei dem erfindungsgemäßen Verfahren wird zum Laden und Lesen von Potentialen an einem Netzwerk mit einem Elektronenstrahl fester Energie gearbeitet. Dies hat zur Folge, daß sich auch während der Meßzeiten $T_R$ jeder einzelne Kontaktpunkt auflädt. Eine Verfälschung der Meßergebnisse infolge der dadurch verursachten Potentialänderung kann vermieden werden, indem man die Meßzeit $T_R$ im Vergleich zur Aufladezeit $T_C$ hinreichend kurz wählt. Sollen die elektrischen Eigenschaften eines aus N Kontaktpunkten bestehenden Leitungsnetzwerkes untersucht und an jedem der Kontaktpunkte jeweils M Messungen durchgeführt werden, so ist zu fordern, daß die Meßzeit $T_R$ kleiner ist als der Bruchteil N x M der Aufladezeit $T_C$. Durch diese Beschränkung der Meßzeit wird das Netzwerk nach M Messungen an N Kontaktpunkten nur auf eine Spannung kleiner als $V_C$ aufgeladen, so daß die Unterscheidung zwischen geladenen und ungeladenen Punkten weiterhin möglich ist.

Mit zunehmender Kontaktpunktzahl N steigt die Kapazität des Netzwerkes und damit auch die Zeit $T_C$ zum Aufbringen des Potentials $V_C$. Dadurch sinkt die zulässige Meßzeit $T_R$ mit steigender Kontaktpunktzahl nicht auf unrealistisch kleine Werte. Je nach vorgegebenem Schwellenwert zur Unterscheidung zwischen geladenen und ungeladenen Punkten wird in der Praxis die längste zulässige Meßzeit $T_R$ größenordnungsmäßig nochmals um etwa den Faktor 2 reduziert. Eine Mindestmeßzeit wird andererseits durch Anforderung an das Signal-Rausch-Verhältnis sowie durch technische Rahmenbedingungen vorgegeben.

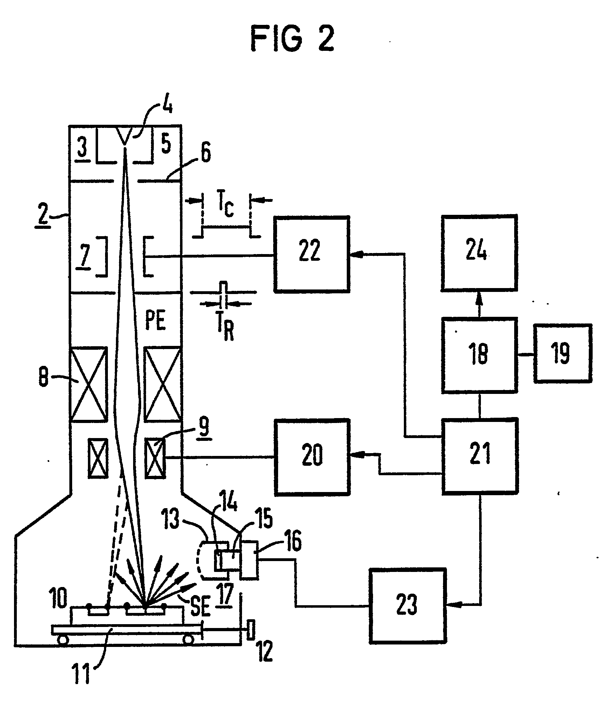

Nach dem in Fig.2 dargestellten Ausführungsbeispiel einer Anordnung zur Durchführung des erfindungsgemäßen Verfahrens wird ein feingebündelter Primärelektronenstrahl PE beispielsweise in der elektronenoptischen Säule 2 eines Raster-Elektronenmikroskopes erzeugt. Neben einer Vielzahl hier nicht gezeigter Magnetspulen und Blenden zur Strahlformung weist diese elektronenoptische Säule eine im wesentlichen aus Kathode 4, Wehnelt-Elektrode 5 und Anode 6 bestehende Elektronenkanone 3, ein Strahltastsystem 7, eine Projektionslinse 8 zur Fokussierung des Elektronenstrahles auf eine Probe 10 und ein Ablenksystem 9 auf. Mit Hilfe der von den Ablenkspulen erzeugten Magnetfelder wird der Primärelektronenstrahl PE auf einer Probe 10, vorzugsweise einer Leiterplatte oder eines Verdrahtungsmoduls, positioniert. Außer magnetischen Ablenksystemen können auch elektrostatische Ablenksysteme eingesetzt werden. Die Probe 10 ist in der evakuierten Kammer auf einem in drei Raumrichtungen beweglichen Tisch 11 montiert und so z.B. mit einer mechanischen Steuereinrichtung 12 bezüglich des Primärelektronenstrahles PE ausrichtbar. Zum Nachweis der vom Primärelektronenstrahl PE auf der Probe 10 ausgelösten Sekundärelektronen SE dient beispielsweise ein aus Abschirmgitter 13, Szintillator 14, Lichtleiter 15 und Fotomultiplier 16 aufgebautes Detektorsystem 17. Vorteilhafterweise wird diesem Detektorsystem ein Gegenfeld-Spektrometer zur quantitativen Potentialmessung vorgeschaltet, um durch Aufbau eines Potentialwalles einen variablen Schwellenwert zur besseren Unterscheidung zwischen geladenen und ungeladenen Punkten eines Netzwerkes setzen zu können. Wird beispielsweise ein Kontaktpunkt auf eine negative Spannung $V_C$ aufgeladen, so verschiebt sich die Energieverteilung der von diesem Punkt emittierten Sekundärelektronen um den Betrag $eV_C$($e$ = Elementarladung) zu höheren Energien. Dies hat zur Folge, daß nahezu alle von geladenen Punkten in den Raumwinkel des Nachweissystems emittierten Sekundärelektronenen den Detektor erreichen, während ein Großteil der von ungeladenen Punkten emittierten und damit niederenergetischeren Sekundärelektronen durch das Gegenfeld des Spektrometers abgeschirmt werden. Die an geladenen und ungeladenen Kontaktpunkten gemessenen Sekundärelektronenströme unterscheiden sich deshalb je nach Höhe des Gegenfeldes erheblich voneinander, so daß sich Kurzschlüsse und Unterbrechungen auch bei niedrigen Aufladespannungen $V_C$ noch sicher nachweisen lassen.

Zur Überprüfung der elektrischen Eigenschaften von Leiterplatten oder Verdrahtungsmodulen mit großen Kontaktpunkzahlen ist es vorteilhaft, das erfindungsgemäße Testverfahren rechnergesteuert durchzuführen. Der Primärelektronenstrahl wird hierbei mit dem Rechner 18 auf einen der Kontaktpunkte positioniert, in dem dieser die in einem Datenspeicher 19 abgelegten Koordinaten des Kontaktpunktes ausliest und die Elektronik des Ablenksystems 20 über ein zwischengeschaltetes Interface 21 ansteuert. Auch die Elektronik des Austastsystems 22 wird vorteilhafterweise vom Rechner 18 in der Weise kontrolliert, daß der Primärelektronenstrahl das zu untersuchende Leitungsnetzwerk beim Aufbringen und Lesen des Potentials $V_C$ jeweils nur innerhalb der Zeiten $T_C$ bzw. $T_R$ trifft und ansonsten ausgeblendet wird. Dies ist schematisch in Fig.2 durch zwei unterschiedlich breite Rechteckimpulse angedeutet. Wie bereits ausführlich erläutert, erfolgt die Unterscheidung zwischen geladenen und ungeladenen Kontaktpunkten durch Vergleich der an den einzelnen Punkten beobachteten Sekundärelektronen-Signale. Dieser Vergleich kann ebenfalls mit dem Rechner 18 durchgeführt werden, indem dieser die an den N Kontaktpunkten des Leitungsnetzwerkes von der Detektorelektronik 23 gelieferten Sekundärelektronensignale speichert, und sofort oder erst nach dem Abtasten aller Kontaktpunkte mit einem Soll-Wert, z.B. dem Sekundärelektronen-Signal am Aufladepunkte, vergleicht. Eventuell notwendige Korrekturen der Sekundärelektronen-Signale werden hierbei ebenfalls vom Rechner durchgeführt. Die so in dem Leitungsnetzwerk festgestellten Kurzschlüsse und Unterbrechungen können anschließend z.B. auf einen Drucker 24 in Form eines Meßprotokolls ausgegeben werden.

Wie in der Beschreibung ausführlich erläutert, erfolgt der Nachweis von Kurzschlüssen und Unterbrechungen in einem Leitungsnetzwerk durch Vergleich der an verschiedenen Kontaktpunkten des Netzwerkes gemessenen Sekundärelektronen-Signale mit einem Referenzwert. Für das erfindungsgemäße Verfahren ist es hierbei nicht entscheidend, welche Art von Teilchen oder Strahlung die Sekundärelektronen auf einer Probe auslösen, da das in einem Detektorsystem zu messende Sekundärelektronen-Signal im wesentlichen nur vom Probenpotential und lokalen elektrischen Feldern abhängt. Zur Durchführung des Verfahrens kann man deshalb mit jeder Art von Korpuskularstrahlen bzw. elektromagnetischer Strahlung arbeiten, bei der auf einer Probe Sekundärelektronen ausgelöst werden.

**Patentansprüche**

1. Korpuskularstrahl-Meßverfahren zum berührungslosen Testen von Leitungsnetzwerken auf Kurzschlüsse und Unterbrechungen, bei dem
   – ein Punkt (1) eines ersten Leitungsnetzwerks innerhalb einer ersten Zeitspanne $T_C$ mit einem Korpuskularstrahl (PE) auf ein erstes Potential $V_C$ aufgeladen wird,
   – der Korpuskularstrahl (PE) anschließend auf eine Anzahl N weiterer Punkte des ersten oder eines zweiten Leitungsnetzwerks gerichtet wird und dort für jeweils eine zweite Zeitspanne $T_R$ verbleibt, dadurch gekennzeichnet, daß diese zweite Zeitspanne so bemessen ist, daß diese der Bedingung $T_R < T_C/N$ genügt,
   – daß die Potentiale der weiteren Punkte durch Nachweis der vom Korpuskularstrahl (PE) jeweils ausgelösten Sekundärelektronen bestimmt werden, wobei die Energie des Korpuskularstrahls (PE) während der ersten und der zweiten Zeitspanne ($T_C$, $T_R$) denselben Wert aufweist
   – und daß die Potentiale der weiteren Punkte jeweils mit dem ersten Potential ($V_C$) verglichen werden.

2. Korpuskularstrahl-Meßverfahren nach Anspruch 1, dadurch **gekennzeichnet**, daß das Aufladen des ersten Leitungsnetzwerkes (10) auf eine Spannung ($V_C$) durch Detektieren der vom Auftreffpunkt des Korpuskularstrahles (PE) emittierten Sekundärelektronen kontrolliert wird.

3. Korpuskularstrahl-Meßverfahren nach Anspruch 1 und 2, dadurch **gekennzeichnet**, daß dem Sekundärelektronen-Detektorsystem ein Gegenfeld-Spektrometer zur quantitativen Potentialmessung vorgeschaltet wird.

4. Korpuskularstrahl-Meßverfahren nach einem der Ansprüche 1 bis 3, dadurch **gekennzeichnet**, daß mit einem Elektronenstrahl Potentiale auf einem Leitungsnetzwerk erzeugt und gemessen werden.

5. Korpuskularstrahl-Meßverfahren nach einem der Ansprüche 1 bis 4, dadurch **gekennzeichnet**, daß der Korpuskularstrahl (PE) zum Aufbringen und Lesen von Potentialen auf einem Leitungsnetzwerk (10) in einem Raster-Elektronenmikroskop erzeugt wird.

6. Korpuskularstrahl-Meßverfahren nach einem der Ansprüche 1 bis 5, dadurch **gekennzeichnet**, daß der Korpuskularstrahl (PE) von einem Rechner (18) über ein Interface (21) durch Ansteuern der Elektronik des Ablenksystems (20) auf die Kontaktpunkte (1-7) eines Leitungsnetzwerkes (10) positioniert wird.

7. Korpuskularstrahl-Meßverfahren nach einem der Ansprüche 1 bis 6, dadurch **gekennzeichnet**, daß der Korpuskularstrahl (PE) von einem Rechner (18) über ein Interface (21) durch Ansteuern der Elektronik des Strahltastsystems (22) ein- und ausgetastet wird.

8. Korpuskularstrahl-Meßverfahren nach einem der Ansprüche 1 bis 7, dadurch **gekennzeichnet**, daß die Koordinaten der Kontaktpunkte (1-7) eines Leitungsnetzwerkes (10) in einem Datenspeicher (19) abgelegt sind.

9. Korpuskularstrahl-Meßverfahren nach einem der Ansprüche 1 bis 8, dadurch **gekennzeichnet**, daß die an den Kontaktpunkten (1-7) eines Leitungsnetzwerkes (10) gemessenen Sekundärelektronensignale zwischengespeichert werden.

10. Korpuskularstrahl-Meßverfahren nach einem der Ansprüche 1 bis 9, dadurch **gekennzeichnet**, daß vor Aufladung des ersten Leitungsnetzwerkes an ungeladenen Kontaktpunkten Referenzsignale gemessen und zwischengespeichert werden.

11. Korpuskularstrahl-Meßverfahren nach einem der Ansprüche 1 bis 10, dadurch **gekennzeichnet**, daß ein Meßprotokoll auf einen Drucker (24) ausgegeben wird.

12. Korpuskularstrahl-Meßverfahren nach einem der Ansprüche 1 bis 11, dadurch **gekennzeichnet**, daß das Leitungsnetzwerk (10) Teil einer hochintegrierten Schaltung ist.

13. Korpuskularstrahl-Meßverfahren nach einem der Ansprüche 1 bis 12, dadurch **gekennzeichnet**, daß die Leitungsnetzwerke (10) in Form von Leiterplatten oder Verdrahtungsmodulen vorliegen.

**Claims**

1. Particle beam measuring method for non-contact testing of interconnect networks for shorts and interruptions, in which a point (1) of a first interconnect network is charged within a first time span $T_C$ by use of a particle beam (PE) to a first potential $V_C$, the particle beam (PE) subsequently being directed onto a number N of further points of the first or of a second interconnect network and remaining there for a second time span ($T_R$) in each case, characterized in that this second time span $T_R$ is dimensioned so that said time span satisfies the condition $T_R < T_C/N$, in that the potentials of the further points are determined by detecting the secondary electrons triggered in each case by the particle bean (PE), the energy of the particle beam (PE) having the same value during the first and the second time span ($T_C$, $T_R$), and in that the potentials of the further points are compared with the first potential ($V_C$) in each case.

2. Particle beam measuring method according to Claim 1, characterized in that the charging of the first interconnect network (10) to a voltage ($V_C$) is controlled by detecting the secondary electrons emitted from the point of incidence of the particle beam (PE).

3. Particle beam measuring method according to Claims 1 and 2, characterized in that for the purpose of quantitative potential measurement an opposing field spectrometer is connected upstream of the secondary electron detector system.

4. Particle beam measuring method according to one of Claims 1 to 3, characterized in that potentials are generated and measured with an electron beam on an interconnect network.

5. Particle beam measuring method according to one of Claims 1 to 4, characterized in that the particle beam (PE) for applying and reading potentials on an interconnect network (10) is generated in a scanning electron microscope.

6. Particle beam measuring method according to one of Claims 1 to 5, characterized in that the particle beam (PE) is positioned onto the contact points (1-7) of an interconnect network (10) by a computer (18) via an interface (21) by controlling the electronics of the deflection system (20).

7. Particle beam measuring method according to one of Claims 1 to 6, characterized in that the particle beam (PE) is gated and blanked by a computer (18) via an interface (21) by controlling the electronics of the beam scanning system (22).

8. Particle beam measuring method according to one of Claims 1 to 7, characterized in that the coordinates of the contact points (1-7) of an interconnect network (10) are filed in a data memory (19).

9. Particle beam measuring method according to one of Claims 1 to 8, characterized in that the secondary electron signals measured at the contact points (1-7) of an interconnect network (10) are intermediately stored.

10. Particle beam measuring method according to one of Claims 1 to 9, characterized in that before the charging of the first interconnect network reference signals are measured at uncharged contact points and intermediately stored.

11. Particle beam measuring method according to one of Claims 1 to 10, characterized in that a test record is output on a printer (24).

12. Particle beam measuring method according to one of Claims 1 to 11, characterized in that the interconnect network (10) is part of an LSI circuit.

13. Particle beam measuring method according to one of Claims 1 to 12, characterized in that the interconnect networks (10) are present in the form of printed circuit boards or wiring modules.

**Revendications**

1. Procédé de mesure utilisant un faisceau corpusculaire pour tester, sans contact, des réseaux de conducteurs pour déterminer s'ils présentent des courts-circuits et des interruptions, et selon lequel
   - on charge un point (1) d'un premier réseau de conducteurs à l'aide d'un faisceau corpusculaire (PE), à un premier potentiel $V_C$, pendant un premier intervalle de temps $T_C$,
   - on dirige ensuite le faisceau corpusculaire (PE) sur un nombre N d'autres points d'un premier ou d'un second réseau de conducteurs et on l'y maintient respectivement pendant un second intervalle de temps $T_R$, caractérisé par le fait que ce second intervalle de temps $T_R$ est dimensionné de telle sorte que la condition $T_R < T_C/N$ est satisfaite,
   - qu'on détermine les potentiels des autres points en détectant les électrons secondaires respectivement émis par le faisceau corpusculaire (PE), l'énergie du faisceau corpusculaire (PE) possédant la même valeur pendant les premier et second intervalles de temps ($T_C$, $T_R$), et
   - que l'on compare les potentiels des autres points respectivement au premier potentiel ($V_C$).

2. Procédé de mesure utilisant un faisceau corpusculaire suivant la revendication 1, caractérisé par le fait que l'on contrôle la charge du premier réseau de conducteurs (10) à une tension ($V_C$) au moyen de la détection des électrons secondaires émis à partir du point d'impact du faisceau corpusculaire (PE).

3. Procédé de mesure utilisant un faisceau corpusculaire suivant les revendications 1 et 2, caractérisé par le fait qu'en amont du système de détection des électrons secondaires on installe un spectromètre à champ inverse permettant une mesure quantitative de potentiel.

4. Procédé de mesure utilisant un faisceau de mesure corpusculaire suivant l'une des revendications 1 à 3, caractérisé par le fait qu'avec un faisceau d'électrons, on produit et on mesure des potentiels dans un réseau de conducteurs.

5. Procédé de mesure utilisant un faisceau corpusculaire suivant l'une des revendications 1 à 4, caractérisé par le fait qu'on produit le faisceau corpusculaire (PE) dans un microscope électronique à balayage pour l'application et la lecture de potentiels à un réseau de conducteurs (10).

6. Procédé de mesure à faisceau corpusculaire suivant l'une des revendications 1 à 5, caractérisé par le fait que le faisceau corpusculaire (PE) est positionné par un calculateur (18), au moyen d'une interface (21), sur les points de contact (1-7) d'un réseau de conducteurs (10), au moyen de la commande de l'électronique du système de déviation (20).

7. Procédé de mesure utilisant un faisceau corpusculaire suivant l'une des revendications 1 à 6, caractérisé par le fait que le faisceau corpusculaire (PE) est appliqué et interrompu par un calculateur (18) par l'intermédiaire d'une interface (21), au moyen de la commande de l'électronique du système (22) de manipulation du faisceau.

8. Procédé de mesure utilisant un faisceau corpusculaire suivant l'une des revendications 1 à 7, caractérisé par le fait que les coordonnées des points de contact (1-7) d'un réseau de conducteurs (10) sont mémorisés dans une mémoires de données (19).

9. Procédé de mesure utilisant un faisceau corpusculaire suivant l'une des revendications 1 à 8, caractérisé par le fait qu'on mémorise temporairement les signaux produits par les électrons secondaires, mesurés au niveau des points de contact (1-7) dans le réseau de conducteurs (10).

10. Procédé de mesure utilisant un faisceau corpusculaire suivant l'une des revendications 1 à 9, caractérisé par le fait qu'on mesure et on mémorise temporairement des signaux de référence en des points de contact non chargés, avant l'application de la charge au premier réseau de conducteurs.

11. Procédé de mesure utilisant un faisceau corpusculaire suivant l'une des revendications 1 à 10, caractérisé par le fait qu'un procès-verbal de mesure est délivré sur une imprimante (24).

12. Procédé de mesure utilisant un faisceau corpusculaire suivant l'une des revendications 1 à 11, caractérisé par le fait que le réseau de conducteurs (10) fait partie d'un circuit à haute densité d'intégration.

13. Procédé de mesure utilisant un faisceau corpusculaire suivant l'une des revendications 1 à 12, caractérisé par le fait que les réseaux de conducteurs (10) se présentent sous la forme de plaquettes à circuits imprimés ou de modules de câblage.

# FIG 1

# FIG 2